# EUROPEAN PATENT SPECIFICATION

(11) **EP 1 726 016 B1**
(45) Date of publication and mention of the grant of the patent: **12.09.2018**
(21) Application number: 05724383.4
(22) Date of filing: 02.03.2005
(51) Int. Cl.: G11C 7/10, G06T 1/60, G09G 5/393

(54) **TECHNIQUE FOR EFFICIENT VIDEO RE-SAMPLING**
EFFIEKTIVES VIDEO UMWANDLUNGSVERFAHREN
TECHNIQUE DE RÉECHANTILLONNAGE VIDÉO EFFICACE

(30) Priority: 15.03.2004 US 553167 P
(43) Date of publication of application: 29.11.2006
(73) Proprietor: Thomson Licensing DTV, 92130 Issy-les-Moulineaux (FR)
(72) Inventor: RUMREICH, Mark, Francis, Indianapolis, IN 46236 (US)
(74) Representative: Vidon Brevets & Stratégie
(86) International application number: PCT/US2005/006824
(87) International publication number: WO 2005/093759

(56) References cited:
- EP-A- 0 419 863
- WO-A-98/41011
- US-A- 5 654 742
- US-B1- 6 259 459

## Description

### CROSS-REFERENCE TO RELATED APPLICATIONS

This application claims priority under 35 U.S.C. 119(e) to U.S. Provisional Patent Application Serial No. 60/553, 1 67, filed on March 15, 2004.

### TECHNICAL FIELD

This invention relates to a technique for efficiently accessing stored values in a memory to permit data re-sampling or the like.

### BACKGROUND ART

Conversion of an analog signal to a digital signal occurs by sampling the analog signal at a particular frequency and storing the samples as corresponding digital samples. Certain applications require that the output sampling rate differ from the input sampling rate. The process of converting the sampling rate or phase is commonly referred to as "re-sampling." In the video regime, data re-sampling occurs whenever a change in the number or structure of image pixels proves desirable, such when converting images of a particular format such as CCIR656 or ATSC to a pixel structure compatible with a particular display device. Data re-sampling also occurs during picture-in-picture processing and electronic picture geometry correction.

Devices that perform data re-sampling generally do so using a polyphase filter. Such filters comprise a collection of individual sub-filters. The combination of sub-filters calculates output pixel values using a weighted sum of surrounding input pixel values. Dynamic control of the weighting coefficients occurs in response to the desired output pixel location with respect to the input pixel locations. At least two surrounding input pixels are used for interpolation. Making use of a larger number of surrounding pixels provides better results at the expense of higher complexity.

For systems that provide horizontal geometry correction, re-sampling occurs in the horizontal direction only and four horizontally adjacent input pixels are used to calculate one output pixel. The four adjacent input pixels used to calculate the one output pixel could constitute the same four pixels used to calculate a previous sample. Alternatively, this four-pixel cluster can undergo a shift by one or two input pixels.

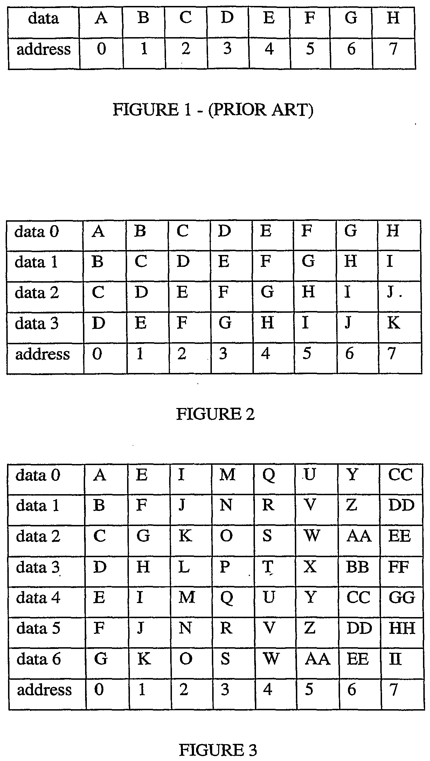

FIGURE 1 shows a prior art linear memory structure 10 in which each memory location stores a single pixel. The data values A, B, C, etc. collectively represent the pixel values of adjacent horizontal pixels. The data structure of FIG. 1 incurs the disadvantage that that four read operations must occur to obtain all four needed adjacent pixel values. If a need exists to read the four adjacent pixels every clock cycle, a problem will exist with memory bandwidth because read operations are limited to one address per clock cycle. Running the memory clock four times faster could solve this problem, but this is often not practical.

Thus a need exists for a technique for obtaining random access to any of a predetermined number of stored values during a single read operation. US6259459B1 discloses an image processing system with a data buffer memory that is provided between an image processor and an image frame memory.

### BRIEF SUMMARY OF THE INVENTION

The invention is defined in the appended method claim 1 and apparatus claim 7. Briefly, in accordance with a preferred embodiment of the present principles, there is provided a method for obtaining from a memory a predetermined group of data values within a specific data value string, the number of whose values exceeds the number of data values in the group by at least unity. The method commences by first generating an address request comprised of a first and second portions. The first portion identifies a specific string of interest whereas the second portion identifies a predetermined group of values of interest within that particular data value string. The first portion of the address request is applied to address the memory to read out the specific data value string during a read operation. The selected string undergoes a masking operation in accordance with the second portion of the address request to select the predetermined group of values within the string. The advantage obtained using this method is that each memory location provides multiple sets of predetermined data value groups, any of which can be obtained during a single read operation.

### BRIEF DESCRIPTION OF THE DRAWINGS

FIGURE 1 depicts a prior art linear memory structure storing a single pixel value at each memory location;
FIGURE 2 depicts a memory structure in accordance with a first embodiment of the present principles for enabling random access of a group of values;
FIGURE 3 depicts a second memory structure in accordance with a second embodiment of the present principles for enabling random access of a group of values; and
FIGURE 4 depicts a block schematic diagram of a read control circuit for a geometry correction system that embodies a memory structure in accordance with the present principles -

### DETAILED DESCRIPTION

As described in greater detail below, the illustrative embodiments each provide a memory structure that enables access of different predetermined groups of values within a string of values stored in a memory such that each of the predetermined group of values can be access during a single read operation.

FIGURE 2 depicts a first embodiment of a memory structure 20 that allows random access of any of a plurality of groups of values during a single read operation. For ease of discussion, each predetermined group comprises four values, and each value typically represents a pixel within an image. However, each group could include more or less than four-values and could include data values of any type.

The memory structure 20 takes the form of M columns of N blocks each where M and N are integers. In the illustrated embodiment of FIG. 2, the block size N equals the number of values in each predetermined value group of interest. In the case of video re-sampling for geometry correction purposes, each predetermined value group contains four values, corresponding to the four adjacent pixel values surrounding a pixel undergoing correction. For the memory structure 20 of FIG. 2, M=7 and N=4. The M columns in the memory structure 10 have separate addresses, indicated for illustration purposes by numbers 0, 1, 2, 3...M.

To facilitate random access, each successive column in the memory structure 20 has N-1 blocks with a value in common with a preceding column. Thus, for example in FIG. 2, the column having address "0" contains four blocks containing the values A, B. C, D, respectively, whereas the columns with addresses "1", and "2" contain the values B, C, D and E, and the values C, D, E and F, respectively. A single read of a particular one of the M columns of the memory structure 20 will yield a particular four-block set of the values.

As compared to the memory structure 10 of FIG. 1, the memory structure 20 of FIG. 2 affords the ability to obtain a particular set of four pixel values during a single read operation, achieving greater efficiency as compared to reading one pixel value at a time. However, the memory structure 20 of FIG. 2 only affords the ability to read a single four block set, often referred to as a pixel phase upon reading of a particular column. Thus, reading the column whose address is "0" yields the single pixel phase A, B, C, and D, achieving an efficiency of 25% (a single pixel phase /four pixel values per column). While the memory structure 20 of FIG. 2 overcomes the memory bandwidth problem of the memory structure 10 of FIG. 1, the low efficiency of the memory structure 20 makes it undesirable for most applications.

FIGURE 3 depicts a memory structure 30 comprised of M columns, each column having N +Y blocks where N and Y are integers greater than zero. As with the memory structure 20 of FIG. 2, each of the M columns of the memory structure 30 has a separate one of addresses 0, 1, 2, 3...M. In the illustrated embodiment, M =8, N=4 and Y=3. Thus, each of the eight columns of the memory structure 30 of FIG. 3 contains seven blocks, as comp ared to the four blocks in each column of the memory structure 20 of FIG. 2. As compared to the memory structure 20 of FIG. 2, each succeeding row of the memory structure 30 has Y blocks in common with each proceeding column.

As will become better understood hereinafter, providing the memory structure 30 with N+Y blocks in each column achieves greater efficiency by affording a greater number of combinations of pixel phases during a single read operation. For example, consider the first column in the memory structure 30 bearing the address "0". This particular column contains the pixel values A, B, C, D, E, F, and G, thus providing the following four pixel phases:

| | | | | |
|---|---|---|---|---|
| Phase 0: | A | B | C | D |
| Phase 1: | B | C | D | E |
| Phase 2: | C | D | E | F |
| Phase 3: | D | E | F | G |

Thus, reading each column of the memory structure 30 of FIG. 3, affords the ability to obtain four different pixel phases.

Selection of a particular one of the phases of pixels stored within each column of the memory structure 30 typically occurs by a decoding process to identify the pixel phase of interest, while masking the remaining pixel phases. To this end, the address request applied to the memory structure 30 has two portions, usually, although not necessarily, at least one most significant bit, and at least one least significant bit. The first portion of the address request, that is, the most significant bit(s) (MSB(s)) identifies the particular column that contains the pixel phase of interest. The second portion of the address request (i.e., the least significant bit(s) or LSB(s) identify the particular pixel phase of interest within the identified column.

With regard to the memory structure 30 illustratively depicted in FIG. 3, the address request comprises a binary five-bit string xxxyy. The three most significant bits (MSBs) of the address request (xxx) designate the particular one of the eight columns of interest, and the two least significant bits (LSBs) (yy) designate the particular pixel phase of interest within that column. In accordance with the LSBs in the address request, a demultiplexer (not shown) or similar device masks the non-selected pixel phases. As compared to the memory structure 20 of FIG. 2, the memory structure 30 of FIG. 3 offers an efficiency of 4/7 (four pixel phases/7 blocks per column) or 57%, which is acceptable for most applications.

Increasing the number of blocks in each column of the memory structure 30 will increase efficiency. Table I depicts the increase in storage efficiency as a function of block size for applications requiring random access of four adjacent pixels where the phases per block vary as function of 2*ⁱ* where *i* is an integer index value. This simplifies address decoding as mentioned previously.

**TABLE I**

| phases per block | block size | storage efficiency |
|---|---|---|
| 4 | 7 | 4/7 = 57% |
| 8 | 11 | 8/11 = 73% |
| 16 | 19 | 16/19 = 84% |
| 32 | 35 | 32/35 = 91% |

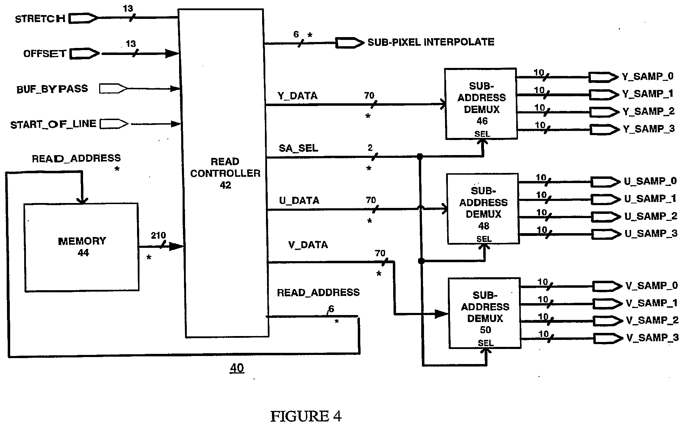

FIGURE 4 illustrates a block diagram of a portion of a geometry correction circuit 40, in accordance with the present principles, for controlling data access to enable a geometry correction in the manner described below. The circuit 40 comprises a read controller 42 that generates a read address for reading data from a memory 44 that stores successive lines of video. Each line of video comprises a plurality of pixel values, each entered into the memory during successive clock cycles. In practice, the memory stores each line of video as separate strings of YUV data. Typically, each column of the memory 44 contains 7 blocks, each storing a concatenated 10-bit value for a separate one of a set of Y, U and V, respectively. To permit fast data transfer, the memory 44 has a two hundred-ten bit bus coupled to the read controller 42 to permit output of each of the seven concatenated values for Y, U and V during a single read operation.

The read controller 42 typically takes the form of a wired element, such as an application specific integrated circuit (ASIC) or programmable gate array (PGA) or any combination of such devices. Alternatively, the read controller 42 could comprise a microprocessor or microcomputer comprised of combination of hardware, software, and firmware. The software would be implemented as an application program tangibly embodied in a program storage device (not shown).

The read control block 42 generates read addresses for accessing the memory 44 in accordance with Stretch signal and an Offset signal, each typically 13 bits in length. The Stretch signal indicates the desired degree of stretching within an image, which in turn, dictates the addressing of the stored pixel values. This can be understood as follows. In the absence of any stretching, the read controller 42 reads successive pixel values out of the memory 44 for each stored line of video upon successive clock signals in the same fashion as the writing of such pixel values to store each line in the memory. In this way, each line of video, represented by a corresponding string of pixels read out of the memory 44 by the read controller 42 should have the same appearance as when read into the memory.

To effect such stretching of the image by a prescribed percentage, the read controller 42 must read out the pixel values in the memory 44 in a fashion to effect stretching of the line of video by that percentage. Thus, to achieve a ten percent stretch, the read controller 42 must read the pixel whose value represents the corresponding portion of the image stretched by that same percentage. Depending on desired degree of stretch, interpolation typically becomes necessary. When interpolation becomes necessary, the read controller 42 will address the memory 44 to obtain the closest pixel value, and will generate a sub-pixel interpolate command for receipt by a down stream interpolator (not shown) to effect the required interpolation.

The offset signal received by the read controller 42 determines the degree to which the addressing of the memory 44 must be offset to effect an offset in the corresponding line of video. For example, assume that a line of video should enjoy a 25 pixel offset. To effect such an offset, the read controller will output successive read addresses for addressing the memory 44 to achieve a 25 pixel offset.

In addition to the Stretch and Offset signals, the read controller 42 receives a buffer bypass signal and a start-of-line signal. The start of line signal initializes a state machine within the read controller at the beginning of each line. The Buffer bypass signal disables geometry correction by setting the Offset and Stretch signals to zero.

The 7 concatenated 10-bit values for the Y, U and V components of each pixel value received from the read controller 42 pass on each of data buses Y_data, V_data and U_data, respectively, to a separate one of a set of sub-address de-multiplexers 46, 48 and 50, respectively. Each of the sub-address multiplexers 46, 48 and 50 receives a two-bit a sample select signal (SA-SEL) generated by the read controller 42 in connection with the read address applied to the memory 44. The SA-SEL applied to each of the sub-address de-multiplexers causes each demultiplexer to select a particular pixel phase within the stream of data applied thereto, while masking the remaining pixel phases.

As can be appreciated, the read controller 42 of FIG. 4 affords selection of a particular one of a set of pixel phases within a string of pixel values read during a single read operation in a manner comparable to that described with respect to the memory structure 30 of FIG. 3. The read address generated by the read controller 42 comprises a first portion of an address request that selects of a particular string of pixel values from the memory 44. The sample select signal (SA-SEL) comprises the second portion of the address request which operates to control the sub-address de-multiplexers 46, 48 and 50 to select the particular pixel phase of interest while masking the other phases. In this way, the read controller 42 operates to read a particular string of pixel values from the memory 44 and select the particular pixel phase during a single read operation.

The foregoing describes a technique for efficiently accessing stored values to obtain any of a set of predetermined values within a string of values during a single read operation.

## Claims

1. A method for obtaining a set of 4 data values within a fixed width data string, from a memory (44) comprising data values stored in successive columns, each column comprising N+Y blocks of data values, N and Y being integers greater than zero, each column starting with Y blocks of data values overlapping with Y blocks of data values ending a preceding column, N being equals to 2*ⁱ*, with i being an integer equals to or greater than 2 , said method comprising the steps of
generating an address request comprised of a first and second portions, the first portion identifying one of the column of the memory, and the second portion having at least two least significant bits identifying the set of 4 data values within the fixed width data string of the identified column,
applying the first portion of the address request as generated to the memory to read out the fixed width data string during a read operation;
masking the fixed width data string in accordance with the second portion of the address request, wherein the masking step comprises:
- applying the fixed-width data string to a de-multiplexer, and
- controlling the de-multiplexer in accordance with the second portion of the address request to select the set of 4 data values within the fixed width data string, wherein data values are pixel values.

2. The method according to claim 1 wherein the fixed-width data string includes at least two more data values than the multiple contiguous data values.

3. The method according to claim 1 wherein the fixed width data string comprises separate sub-strings, and wherein the masking step further comprises the step of masking each substring in accordance with the second portion of the address request.

4. The method according to claim 3 wherein the sub strings comprise Y, U and V pixel data.

5. The method of claim 4, wherein the first portion of the address request identifies the fixed width data string of Y, U and V values , and the second portion identifies a sub-string of Y, U and V values within the fixed width data string of Y, U and V values, said steps of
masking the fixed width data string and controlling the de-multiplexer enabling read out of sub-strings of Y, U and V values in a single read operation to reduce memory access latency.

6. The method according to claim 5 further comprising the step of processing the Y, U and V pixel values..

7. Apparatus for accessing a set of 4 data values within a fixed width data string, wherein data values are pixel values, , said apparatus comprising:
a memory (44) for storing at least the fixed width data string values and for reading out the fixed width data, said data values in said memory being stored in successive columns, each column comprising N+Y blocks of data values, N and Y being integers greater than zero, each column starting with Y blocks of data values overlapping with Y blocks of data values ending a preceding column, N being equals to 2*ⁱ*, with i being an integer equals to or greater than 2,
an address generator (42) for generating an address request comprised of a first and second portions, the first portion identifying one of the column of the memory , and the second portion having at least two significant bits identifying the set of 4 data values within the fixed width data string of the identified column,
; and
at least one de-multiplexer (46, 48, 50) for masking the fixed width data string in accordance with the second portion of the address request to select the set of 4 data values within the fixed width data string.

8. The apparatus according to claim 7 wherein the fixed width string of values comprises separate sub-strings.

9. The apparatus according to claim 7 further including a plurality of demultiplexers, each separately masking a corresponding each substring in accordance with the second portion of the address request.

## Patentansprüche

1. Verfahren zum Erhalten einer Menge von 4 Datenwerten innerhalb einer Datenfolge fester Breite aus einem Speicher (44), der Datenwerte umfasst, die in aufeinanderfolgenden Spalten gespeichert sind, wobei jede Spalte N + Y Blöcke von Datenwerten umfasst, wobei N und Y ganze Zahlen größer als null sind, wobei jede Spalte mit Y Blöcken von Datenwerten beginnt, die mit Y Blöcken von Datenwerten, die eine vorhergehende Spalte beenden, überlappen, wobei N gleich 2ⁱ ist, wobei i eine ganze Zahl gleich oder größer als 2 ist, wobei das Verfahren die folgenden Schritte umfasst:
Erzeugen einer Adressenanforderung, die aus einem ersten und aus einem zweiten Abschnitt besteht, wobei der erste Abschnitt eine der Spalten des Speichers identifiziert und wobei der zweite Abschnitt mindestens zwei niedrigstwertige Bits aufweist, die die Menge von 4 Datenwerten innerhalb der Datenfolge fester Breite der identifizierten Spalte identifizieren,
Anwenden des ersten Abschnitts der Adressenanforderung, wie sie erzeugt wurde, auf den Speicher, um die Datenfolge fester Breite während einer Leseoperation auszulesen;
Maskieren der Datenfolge fester Breite in Übereinstimmung mit dem zweiten Abschnitt der Adressenanforderung, wobei der Schritt des Maskierens umfasst:
- Anwenden der Datenfolge fester Breite auf einen Demultiplexer, und
- Steuern des Demultiplexers in Übereinstimmung mit dem zweiten Abschnitt der Adressenanforderung, um die Menge von 4 Datenwerten innerhalb der Datenfolge fester Breite auszuwählen, wobei die Datenwerte Pixelwerte sind.

2. Verfahren nach Anspruch 1, wobei die Datenfolge fester Breite mindestens zwei Datenwerte mehr als die mehreren zusammenhängenden Datenwerte enthält.

3. Verfahren nach Anspruch 1, wobei die Datenfolge fester Breite getrennte Teilfolgen umfasst und wobei der Schritt des Maskierens ferner den Schritt des Maskierens jeder Teilfolge in Übereinstimmung mit dem zweiten Abschnitt der Adressenanforderung umfasst.

4. Verfahren nach Anspruch 3, wobei die Teilfolgen Y-, U- und V-Pixeldaten umfassen.

5. Verfahren nach Anspruch 4, wobei der erste Abschnitt der Adressenanforderung die Datenfolge fester Breite von Y-, U- und V-Werten identifiziert und wobei der zweite Abschnitt innerhalb der Datenfolge fester Breite von Y-, U- und V-Werten eine Teilfolge von Y-, U- und V-Werten identifiziert, wobei die Schritte des
Maskierens der Datenfolge fester Breite und des Steuerns des Demultiplexers das Auslesen der Teilfolgen von Y-, U- und V-Werten in einer einzigen Leseoperation, um die Speicherzugriffslatenzzeit zu verringern, ermöglichen.

6. Verfahren nach Anspruch 5, das ferner den Schritt des Verarbeitens der Y-, U- und V-Pixelwerte umfasst.

7. Vorrichtung zum Zugreifen auf eine Menge von 4 Datenwerten innerhalb einer Datenfolge fester Breite, wobei die Datenwerte Pixelwerte sind, wobei die Vorrichtung umfasst:
einen Speicher (44) zum Speichern mindestens der Werte der Datenfolge feste Breite und zum Auslesen der Daten fester Breite, wobei die Datenwerte in dem Speicher in aufeinanderfolgenden Spalten gespeichert sind, wobei jede Spalte N + Y Blöcke von Datenwerten umfasst, wobei N und Y ganze Zahlen größer als null sind, wobei jede Spalte mit Y Blöcken von Datenwerten beginnt, die mit Y Blöcken von Datenwerten, die eine vorhergehende Spalte beenden, überlappen, wobei N gleich 2ⁱ ist, wobei i eine ganze Zahl gleich oder größer als 2 ist,
einen Adressengenerator (42) zum Erzeugen einer Adressenanforderung, die aus einem ersten und aus einem zweiten Abschnitt besteht, wobei der erste Abschnitt eine der Spalten des Speichers identifiziert und wobei der zweite Abschnitt mindestens zwei niedrigstwertige Bits aufweist, die die Menge von 4 Datenwerten innerhalb der Datenfolge fester Breite der identifizierten Spalte identifizieren; und
mindestens einen Demultiplexer (46, 48, 50) zum Maskieren der Datenfolge fester Breite in Übereinstimmung mit dem zweiten Abschnitt der Adressenanforderung, um die Menge der 4 Datenwerte innerhalb der Datenfolge fester Breite auszuwählen.

8. Vorrichtung nach Anspruch 7, wobei die Folge fester Breite von Werten getrennte Teilfolgen umfasst.

9. Vorrichtung nach Anspruch 7, die ferner mehrere Demultiplexer enthält, die jeweils eine entsprechende jeweilige Teilfolge in Übereinstimmung mit dem zweiten Abschnitt der Adressenanforderung getrennt maskieren.

## Revendications

1. Procédé pour obtenir un ensemble de 4 valeurs de données dans une chaîne de données de largeur fixe, depuis une mémoire (44) comprenant des valeurs de données stockées dans des colonnes successives, chaque colonne comprenant N+Y blocs de valeurs de données, N et Y étant des entiers supérieurs à zéro, chaque colonne commençant par Y blocs de valeurs de données chevauchant Y blocs de valeurs de données terminant une colonne précédente, N étant égal à 2ⁱ, où i est un entier supérieur ou égal à 2, ledit procédé comprenant les étapes suivantes :
génération d'une demande d'adresse constituée d'une première et d'une deuxième parties, la première partie identifiant l'une des colonnes de la mémoire et la deuxième partie ayant au moins deux bits de poids faible identifiant l'ensemble de 4 valeurs de données dans la chaîne de données de largeur fixe de la colonne identifiée,
application de la première partie de la demande d'adresse telle que générée à la mémoire pour lire la chaîne de données de largeur fixe pendant une opération de lecture ;
masquage de la chaîne de données de largeur fixe conformément à la deuxième partie de la demande d'adresse, où l'étape de masquage comprend :
- l'application de la chaîne de données de largeur fixe à un démultiplexeur, et
- le contrôle du démultiplexeur conformément à la deuxième partie de la demande d'adresse pour sélectionner l'ensemble de 4 valeurs de données dans la chaîne de données de largeur fixe, où les valeurs de données sont des valeurs de pixel.

2. Procédé selon la revendication 1, dans lequel la chaîne de données de largeur fixe inclut au moins deux valeurs de données de plus que les valeurs de données contiguës multiples.

3. Procédé selon la revendication 1, dans lequel la chaîne de données de largeur fixe comprend des sous-chaînes distinctes, et dans lequel l'étape de masquage comprend en outre l'étape de masquage de chaque sous-chaîne conformément à la deuxième partie de la demande d'adresse.

4. Procédé selon la revendication 3, dans lequel les sous-chaînes comprennent des données de pixel Y, U et V.

5. Procédé selon la revendication 4, dans lequel la première partie de la demande d'adresse identifie la chaîne de données de largeur fixe de valeurs Y, U et V, et la deuxième partie identifie une sous-chaîne de valeurs Y, U et V dans la chaîne de données de largeur fixe de valeurs Y, U et V, lesdites étapes de
masquage de la chaîne de données de largeur fixe et de contrôle du démultiplexeur permettant de lire des sous-chaînes de valeurs Y, U et V lors d'une seule opération de lecture pour réduire la latence d'accès à la mémoire.

6. Procédé selon la revendication 5, comprenant en outre l'étape de traitement des valeurs de pixel Y, U et V.

7. Appareil pour accéder à un ensemble de 4 valeurs de données dans une chaîne de données de largeur fixe, dans lequel les valeurs de données sont des valeurs de pixel, ledit appareil comprenant :
une mémoire (44) pour stocker au moins les valeurs de la chaîne de données de largeur fixe et pour lire les données de largeur fixe, lesdites valeurs de données dans ladite mémoire étant stockées dans des colonnes successives,
chaque colonne comprenant N+Y blocs de valeurs de données, N et Y étant des entiers supérieurs à zéro,
chaque colonne commençant par Y blocs de valeurs de données chevauchant Y blocs de valeurs de données terminant une colonne précédente, N étant égal à 2i, où i est un entier supérieur ou égal à 2,
un générateur d'adresse (42) pour générer une demande d'adresse constituée d'une première et d'une deuxième parties, la première partie identifiant l'une des colonnes de la mémoire et la deuxième partie ayant au moins deux bits de poids faible identifiant l'ensemble de 4 valeurs de données dans la chaîne de données de largeur fixe de la colonne identifiée,
et
au moins un démultiplexeur (46, 48, 50) pour masquer la chaîne de données de largeur fixe conformément à la deuxième partie de la demande d'adresse pour sélectionner l'ensemble de 4 valeurs de données dans la chaîne de données de largeur fixe.

8. Appareil selon la revendication 7, dans lequel la chaîne de valeurs de largeur fixe comprend des sous-chaînes distinctes.

9. Appareil selon la revendication 7, comprenant en outre une pluralité de démultiplexeurs, chacun masquant séparément une sous-chaîne correspondante conformément à la deuxième partie de la demande d'adresse.
